# EUROPÄISCHE PATENTSCHRIFT

(11) **EP 1 002 688 B1**
(45) Veröffentlichungstag und Bekanntmachung des Hinweises auf die Patenterteilung: **04.05.2005**
(21) Anmeldenummer: 99810769.2
(22) Anmeldetag: 26.08.1999
(51) Int. Cl.: B60L 9/24, H02M 7/00

(54) **Modul einer, vorzugsweise in einem Antrieb für ein Schienenfahrzeug enthaltenen, modular aufgebauten Schaltungsanordnung**
Module of a circuit with modular construction, preferably contained in a railway vehicle drive
Module d'un circuit à configuration modulaire, de préférence contenu dans un agencement d'un véhicule ferroviaire

(30) Priorität: 09.09.1998 DE 19841133
(43) Veröffentlichungstag der Anmeldung: 24.05.2000
(73) Patentinhaber: Bombardier Transportation GmbH, 13627 Berlin (DE)
(72) Erfinder: Berth, Matthias Dr., 5400 Baden (CH); Schifferli, Rolf, 5276 Wil (CH)
(74) Vertreter: COHAUSZ & FLORACK

(56) Entgegenhaltungen:
- US-A- 5 434 770
- US-A- 5 566 060
- US-A- 5 616 968
- US-A- 5 735 710
- CRAMER G ET AL: "MODULARE ENERGIEVERSORGUNG FUER REISEZUGWAGEN" ELEKTRISCHE BAHNEN, OLDENBOURG VERLAG. MUNCHEN, DE, Bd. 96, Nr. 8, 1. August 1998 (1998-08-01), Seiten 261-265, XP000777446 ISSN: 0013-5437

## Beschreibung

Bei der Erfindung wird ausgegangen von einem Modul einer, vorzugsweise in einem Antrieb für ein Schienenfahrzeug enthaltenen, modular aufgebauten Schaltungsanordnung nach dem Oberbegriff von Patentanspruch 1.

### STAND DER TECHNIK

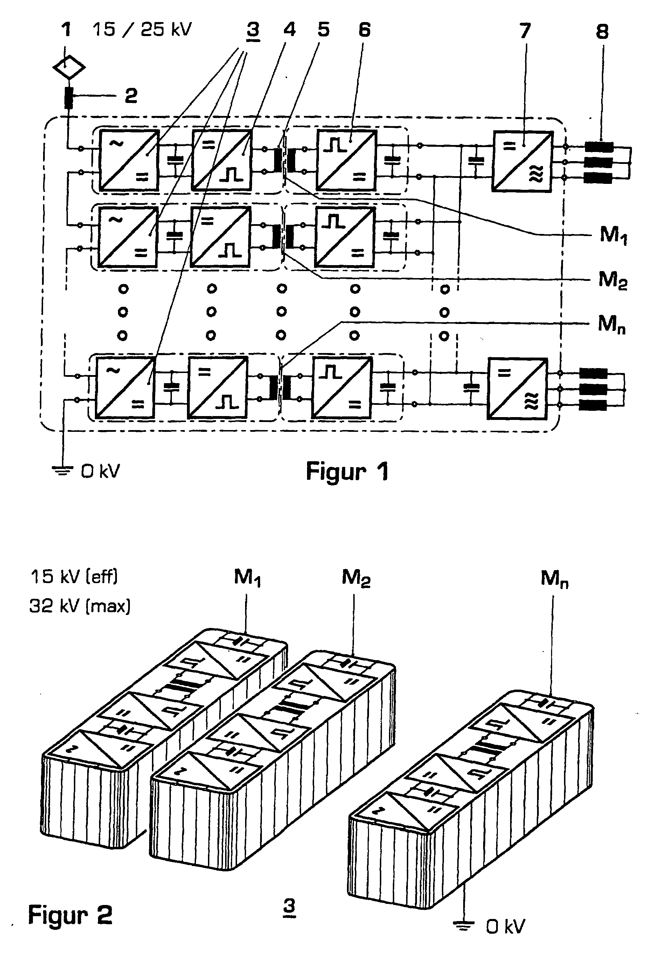

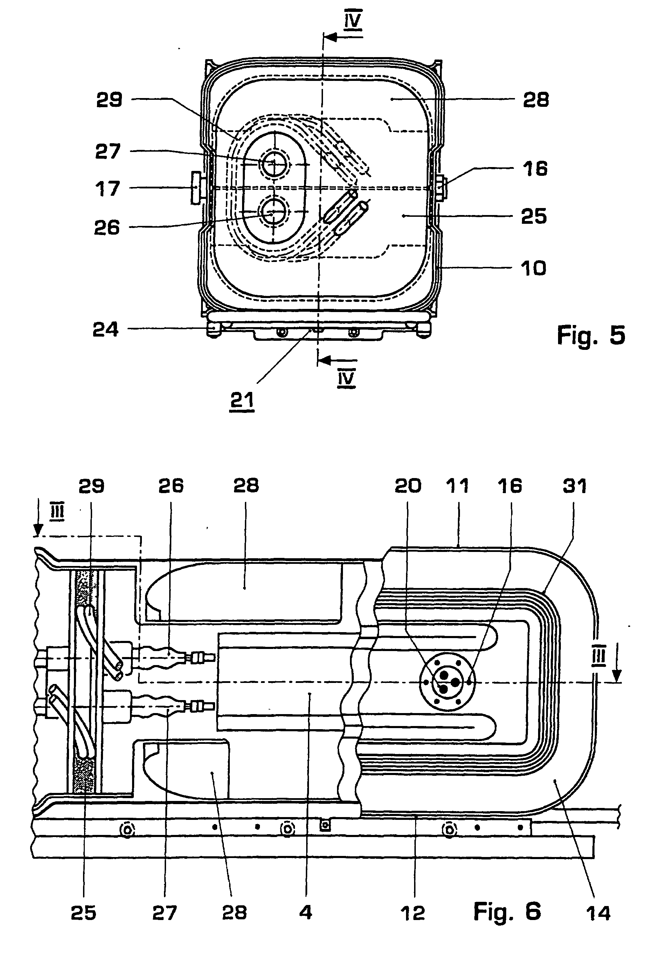

Ein Modul der vorgenannten Art ist insbesondere in Fig.6 von DE 196 30 284 A1 beschrieben. Das Modul ist Bestandteil einer Schaltungsanordnung mit n miteinander in Serie geschaltete Stromrichtermodule 40.1,......40.n, deren Ausgänge zueinander parallel geschaltet sind. Die Ausgänge sind verbindbar mit Stromrichtermodulen 41.1, ...41.m mit jeweils einem Antriebsmotor 42.1,...,42.m. In den Stromrichtermodulen 40.1, ...40.n wird die relativ hohe Wechselspannung zwischen Fahrdraht 36 und Schiene 37 eines Antriebs für ein Schienenfahrzeug entsprechend der Anzahl n der Stromrichtermodule aufgeteilt. An den Ausgängen der Stromrichtermodule 40.1,....40.n steht eine entsprechend der Anzahl der Module n reduzierte, von der Eingangsspannung jeweils durch einen Transformator 6 (Fig.1) galvanisch getrennte geringe Ausgangsspannung an, welche über die Stromrichtermodule 43.1,...,43.m in die Antriebsmotore 42.1,...42.m einspeist. Umgekehrt können auch die Antriebsmotoren beim Abbremsen des Schienenfahrzeugs über die Teilstromrichtermodule ins Netz einspeisen. Da alle Stromrichtermodule lediglich mit einer geringen Spannung beaufschlagt sind, können sie in kostengünstiger Weise mit Halbleiterschaltern 11 (Fig.1) üblicher Spannungsfestigkeit betrieben werden.

Die US 4 434 770 A beschreibt eine Hochspannungsversorgungseinrichtung, die aus mehreren Modulen gebildet ist, welche Reihenresonanz-Halbbrückeninverter enthalten. Die Module weisen eine auf Hochspannungspotential befindliche erste leistungselektronische Baugruppe, eine auf niedrigerem Potential befindliche zweite leistungselektronische Baugruppe und einen die erste und die zweite Baugruppe unter Bildung einer galvanischen Trennstelle koppelnden Transformator auf.

### KURZE DARSTELLUNG DER ERFINDUNG

Der Erfindung, wie sie in den Patentansprüchen angegeben ist, liegt die Aufgabe zugrunde, ein Modul für eine modular aufgebaute Schaltungsanordnung anzugeben, welches sich durch eine kompakte Bauweise auszeichnet und gleichzeitig in der Lage ist, eine grosse Leistung von Hochspannungspotential auf einen auf Masse oder Erdpotential befindlichen Verbraucher bzw. vom Verbraucher abgegebene Leistung von niedrigem Potential auf Hochspannungspotential zu übertragen.

Bei diesem Modul sind zumindest eine auf Hochspannungspotential befindliche erste leistungselektronische Baugruppe sowie mit dieser Baugruppe verbundene Stromanschlüsse eines eine zweite leistungselektronische Baugruppe unter Bildung einer galvanischen Trennstelle koppelnden Transformators in einem weitgehend quaderförmig ausgebildeten Isolierstoffgehäuse angeordnet, weist das Isolierstoffgehäuse auf seiner Deck- und Bodenfläche sowie auf seiner nach vorne abgeschlossenen Frontseite jeweils eine auf Masse oder Erdpotential geführte elektrisch leitende Schicht auf, und ist durch die beiden Seitenflächen des Isolierstoffgehäuses jeweils ein Stromanschluss der ersten leistungselektronischen Baugruppe geführt. Zudem umfasst die elektrische Isolierung zwischen der ersten leistungselektronischen Baugruppe und den auf Masse oder Erdpotential geführten elektrisch leitenden Schichten einen im wesentlichen U-förmig ausgebildeten und von der Deckfläche über die Frontseite auf die Bodenfläche erstreckten Abschnitt der Wand des Isoliergehäuses. Durch diese Maßnahmen wird in vorteilhafter Weise die erwünschte Leistungsübertragung erreicht und kann zugleich in äusserst einfacher Weise ein defektes Modul aus der Schaltungsanordung entfernt und durch ein neues Modul ersetzt werden.

In einer fertigungstechnisch besonders begünstigten Ausführungsform des erfindungsgemässen Moduls sind der gesamte Transformator und zudem auch die zweite leistungselektronische Baugruppe im Isolierstoffgehäuse angeordnet, und nimmt das Isolierstoffgehäuse ferner eine isolierende Zwischenwand auf, welche die erste Baugruppe vom Transformator und der zweiten Baugruppe trennt, und durch welche die auf Hochspannungspotential befindlichen Stromanschlüsse des Transformators geführt sind.

### KURZE BESCHREIBUNG DER ZEICHNUNG

Ein bevorzugtes Ausführungsbeispiel der Erfindung und die damit erzielbaren weiteren Vorteile werden nachfolgend anhand von Zeichnungen näher erläutert. Hierbei zeigt:
- Fig.1: ein Blockschaltbild des Antriebs eines Schienenfahrzeugs mit einer modular aufgebauten Schaltungsanordnung,
- Fig.2: eine perspektivische Ansicht der stark vereinfacht dargestellten Schaltungsanordnung gemäss Fig.1,
- Fig.3: eine Aufsicht auf ein erfindungsgemässes Modul M₂ der Schaltungsanordnung nach den Figuren 1 und 2, welches längs einer aus Fig.4 ersichtlichen Linie III - III geschnitten ist,
- Fig.4: eine Seitenansicht des längs der Linie IV - IV geschnittenen Moduls M₂ nach Fig.3, bei der ein nicht geschnittener Teil des Moduls geringfügig vergrössert dargestellt ist,
- Fig.5: eine Ansicht von links auf das längs der Linie V - V geschnittene Modul M₂ nach Fig.3,
- Fig.6: in vergrösserter Darstellung ein Teil des Moduls gemäss Fig.4,
- Fig.7: in vergrösserter Darstellung ein in Fig.3 umrandet dargestellter Abschnitt eines Isolierstoffgehäuses des Moduls M₂, und
- Fig.8: ein Diagramm, in dem die Verteilung der am Isolierstoffgehäuseabschnitt gemäss Fig.7 wirkenden elektrischen Feldstärke längs einer Testlinie dargestellt ist.

### WEGE ZUR AUSFÜHRUNG DER ERFINDUNG

In allen Figuren beziehen sich gleiche Bezugszeichen auf gleichwirkende Teile. Der als Blockschaltbild dargestellte Antrieb für ein Schienenfahrzeug enthält einen an eine Hochspannungsleitung von beispielsweise 15 bzw. 25 kV Wechselspannung führbaren Stromabnehmer 1, der über eine Eingangsdrosselspule 2 mit einem auf Hochspannungspotential befindlichen ersten Eingang einer Schaltungsanordnung 3 verbunden ist. Ein zweiter Eingang der Schaltungsanordnung 3 ist mit Erdpotential oder Masse verbunden. Die Schaltungsanordnung 3 ist aus n (n= 2, 3, ...) in Reihe geschalteten, jeweils eine galvanische Trennstelle aufweisenden, leistungselektronischen Modulen M₁, M₂,...Mₙ aufgebaut, von denen das Modul M₁ an Hochspannungspotential und das Modul Mₙ an Masse oder Erdpotential geführt ist. Die Module sind identisch aufgebaut und weisen jeweils eine von einem Isolierstoffgehäuse umschlossene, als Stromrichtersystem ausgebildete Leistungselektronik auf sowie zwei Eingänge, von denen ein erster mit dem in der Reihenschaltung vorgeschalteten und ein zweiter mit dem in der Reihenschaltung nachgeschalteten Modul verbunden ist. Abweichend davon ist beim Modul M₁ der erste Eingang auf Hochspannungspotential und beim Modul Mₙ der zweite Eingang auf Erdpotential oder Masse geführt. Jedes Modul weist eine mit den beiden Eingängen verbundene leistungselektronischen Baugruppe 4 auf, einen eine galvanische Trennstelle bildenden Transformator 5 und eine dem Transformator 5 nachgeschaltete leistungselektronischen Baugruppe 6 mit zwei aus dem Modul geführten Ausgängen. Die Ausgänge liegen parallel und sind über m (m=1, 2,...) Stromrichtersysteme 7 mit m Antrieben 8 verbunden.

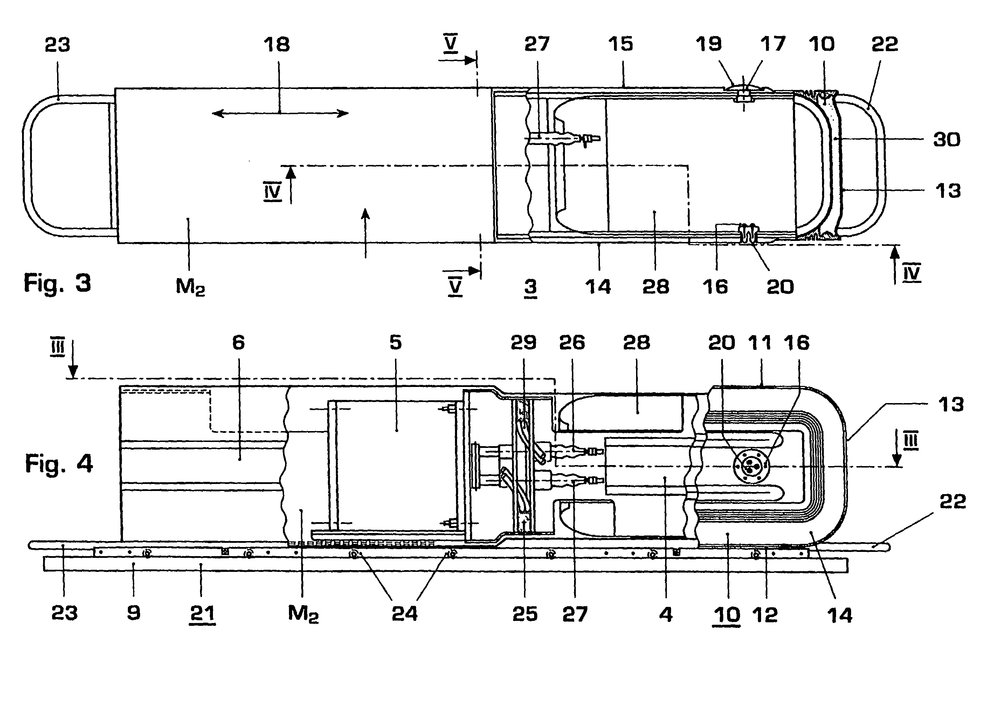

Wie aus den Fig.2 bis 6 ersichtlich ist, sind die Module im wesentlichen quaderförmig ausgebildet und sind zueinander parallel und im Vergleich zu ihrer Höhe mit geringem Abstand voneinander auf einer auf Masse oder Erdpotential befindlichen Platte 9 (Fig.4) angeordnet. Die Module weisen jeweils ein vorwiegend quaderförmig ausgebildetes Isolierstoffgehäuse 10 auf. Auf ihrer Deck- 11 und Bodenfläche 12 sowie ihrer nach vorne abgeschlossenen Frontseite 13 enthalten die Isolierstoffgehäuse 10 jeweils eine auf Masse oder Erdpotential führbare elektrisch leitende Schicht. Durch die einander zugewandten Seitenflächen 14, 15 jeweils zweier benachbarter Module ist jeweils ein Stromanschluss für einen Kontakt einer die Serienschaltung der Baugruppen 4 herstellenden Kontaktanordnung geführt.

Die Module M₁, M₂,..., sind jeweils senkrecht zur Frontseite 13 des Isolierstoffgehäuses 10 auf der Platte 9 verschiebbar gelagert. Die Kontaktanordnung ist durch gegenseitiges Verschieben zweier benachbarter Module betätigbar. Einer der beiden Kontakte 16, 17 der Kontaktanordnung, nämlich der Kontakt 17, weist eine schräg zur Schubrichtung (Doppelpfeil 18 in Fig.3) ausgerichtete Führungsfläche 19 auf, die beim Verschieben mit dem Gegenkontakt 16 zusammenwirkt und je nach Schubrichtung des Moduls in oder ausser Eingriff mit federnd gelagerten Stiften 20 des Gegenkontakts 16 kommt.

Aus Fig.4 ist ersichtlich, dass an der Bodenfläche des Moduls M₂ ein schlittenförmiges, im wesentlichen rechteckiges Führungselement 21 mit Handgriffen 22, 23 angebracht ist. Dieses Führungselement weist an seinen als Kufen wirkenden Längsseiten Rollen 24 auf, welche auf zwei nicht dargestellten, in die Platte 9 eingeformten Schienen geführt sind. An der Front- 13 und/oder der Rückseite des Isolierstoffgehäuses 10 überragen die Handgriffe das Isolierstoffgehäuse 10.

Aus den Figuren 4 bis 6 kann ferner entnommen werden, dass der Transformator 5 und die leistungselektronische Baugruppe 6 im Isolierstoffgehäuse angeordnet sind, und dass das Isolierstoffgehäuse 10 ferner eine isolierende Zwischenwand 25 aufnimmt, welche die im rechten Teil des Isolierstoffgehäuses 10 angeordnete leistungselektronischen Baugruppe 4 vom Transformator 5 und der zweiten leistungselektronischen Baugruppe 6 trennt. Durch die Zwischenwand 25 sind die auf Hochspannungspotential befindlichen Stromanschlüsse des Transformators 5 geführt. Vorzugsweise sind die durch die Zwischenwand 25 geführten Stromanschlüsse jeweils nach Art eines Kabelendverschlusses 26, 27 ausgeführt. Hierdurch werden mit einfachen Mitteln am Übergang von der auf Hochspannungspotential befindlichen leistungselektronischen Baugruppe 4 auf die auf niedrigerem Potential befindliche leistungselektronische Baugruppe 6 vorteilhafte dielektrische Eigenschaften, wie insbesondere grosse Durchschlagsfestigkeit und gutes Kriechstromverhalten, erreicht. Besonders günstige dielektrische Eigenschaften werden erzielt, wenn die Kabelendverschlüsse 26, 27 fest mit der Zwischenwand 25 verbunden sind und in einen durch eine kappenförmige Steuerelektrode 28 abgeschirmten, die leistungselektronische Baugruppe 4 aufnehmenden Raum des Isolierstoffgehäuses 10 ragen. Durch Abstimmung der Gestalt der Steuerelektrode 28 an die Anordnung und die Ausbildung der Kabelendverschlüsse 26, 27 werden das dielektrische Verhalten des Moduls zusätzlich verbessert.

Zur Erhöhung der übertragenen Leistung sind in die isolierende Zwischenwand 25 Kühlkanäle 29 eingeformt, durch welche der Kühlung der leistungselektronischen Baugruppen 4, 6 und des Transformators 5 dienendes Kühlmittel geführt ist. Dieses Kühlmittel ist mit Vorteil eine Flüssigkeit, beispielsweise Wasser, welches durch Schläuche geleitet wird, die in den Kühlkanälen 29 verlegt sind.

Aus fertigungstechnischen Gründen zu bevorzugen ist eine Ausführungsform des Moduls M₂, bei dem die leistungselektronischen Baugruppen 4 und 6 sowie der Transformator 5 in das Isolierstoffgehäuse 10 eingesteckt sind. Im Wartungsfall wird das Modul dann aus der Schaltungsanordnung 3 herausgeschoben und können dann die einzelnen Baugruppen 4, 6 oder der Transformator 5 aus dem Isolierstoffgehäuse 10 rasch herausgezogen werden. Es ist jedoch auch möglich, das Isolierstoffgehäuse 10 klein zu halten und lediglich die leistungselektronischen Baugruppe 4 und die als Kabelendverschlüsse 26, 27 ausgebildeten Stromanschlüsse des Transformators 5 im Isolierstoffgehäuse 10 anzuordnen.

Wie aus Fig.3 entnommen werden kann, weist das Isolierstoffgehäuse 10 an der Frontseite einen Wandabschnitt 30 auf, welcher gegenüber der Wandstärke des Isolierstoffgehäuses im Bereich der Seitenflächen 14, 15 besonders dick ausgeführt ist. Dieser Abschnitt 30 ist im wesentlichen U-förmig ausgebildet und erstreckt sich von der Deckfläche 11 über die Frontseite 13 auf die Bodenfläche 12. Der U-förmige Abschnitt 30 stellt die elektrische Isolation zwischen der auf Hochspannungspotential führbaren leistungselektronischen Baugruppe 4 und den mit Masse oder Erdpotential beaufschlagbaren und mit elektrisch leitenden Schichten versehenen Aussenflächen, nämlich Deckfläche 11, Frontseite 13 und Bodenfläche 12, des Isolierstoffgehäuses 10 sicher. Der U-förmige Wandabschnitt 30 des Isolierstoffgehäuses weist eine geringere elektrische Kapazität pro Flächeneinheit auf als dessen die Seitenflächen 14, 15 bildenden Wandabschnitte.

Der U-förmige Wandabschnitt 30 enthält einen Werkstoff mit einer geringeren Dielektrizitätskonstanten als der die Seitenflächen 14, 15 bildende Werkstoff des Isolierstoffgehäuses 10. Der Werkstoff des U-förmigen Wandabschnitts 30 weist mit Vorteil Porenstruktur auf und ist vorzugsweise als Schaumstoff oder hohlkugelgefüllter Kunststoff ausgeführt. Mit einem solchen Werkstoff lassen sich Dielektrizitätskonstanten von ca. 2 erzielen. Ein Werkstoff mit geringer Dielektrizitätskonstante und zusätzlich hoher mechanischer Festigkeit kann Sandwichstruktur aufweisen mit einer die Aussen- und einer die Innenfläche des Wandabschnitts bildenden Schicht jeweils aus einem mechanisch hochwertigen Isoliermaterial, beispielsweise einem Laminat etwa auf der Basis Epoxy und Glasfaser, und einer dazwischen angeordneten dickeren Schicht aus einem Werkstoff mit geringer Dielektrizitätskonstanten, beispielsweise Schaumstoff oder hohlkörpergefüllter Kunststoff. Das hierbei verwendete Laminat bildet auch die Seitenflächen 14, 15 und weist eine Dielektrizitätskonstante von mindestens vier auf, wohingegen die Dielektrizitätskonstante des Werkstoffs mit Sandwichstruktur einen mittleren Wert von etwas mehr als 2 aufweist.

Zur Verbesserung der Isolation ist zwischen der Baugruppe 4 und dem U-förmigen Wandabschnitt 30 die kappenförmige Steuerelektrode 28 angeordnet. Diese Steuerelektrode ist mit Abstand zum Wandabschnitt 30 angeordnet und zwar so, dass der Abstand von der Frontseite 13 des Isolierstoffgehäuses 10 zur vom Transformator gebildeten galvanischen Trennstelle hin zunimmt. Hierdurch wird das elektrische Feld zwischen Hochspannungspotential und Masse bzw. Erdpotential besonders gut homogenisiert und werden dielektrisch ungünstige Feldüberhöhungen weitgehend vermieden. Die Steuerelektrode 28 besteht mit Vorteil aus elektrisch leitendem Kunststoff und weist auf ihrer Innenseite eine metallische Beschichtung auf. Zusammen mit der auf der Deckfläche 11, der Frontseite 13 und der Bodenfläche 12 angebrachten metallischen Beschichtung des U-förmigen Wandabschnitts 30 lässt sich so das elektrische Feld des Moduls M₂ besonders gut kapazitiv steuern und so äusserst vorteilhaft homogenisieren.

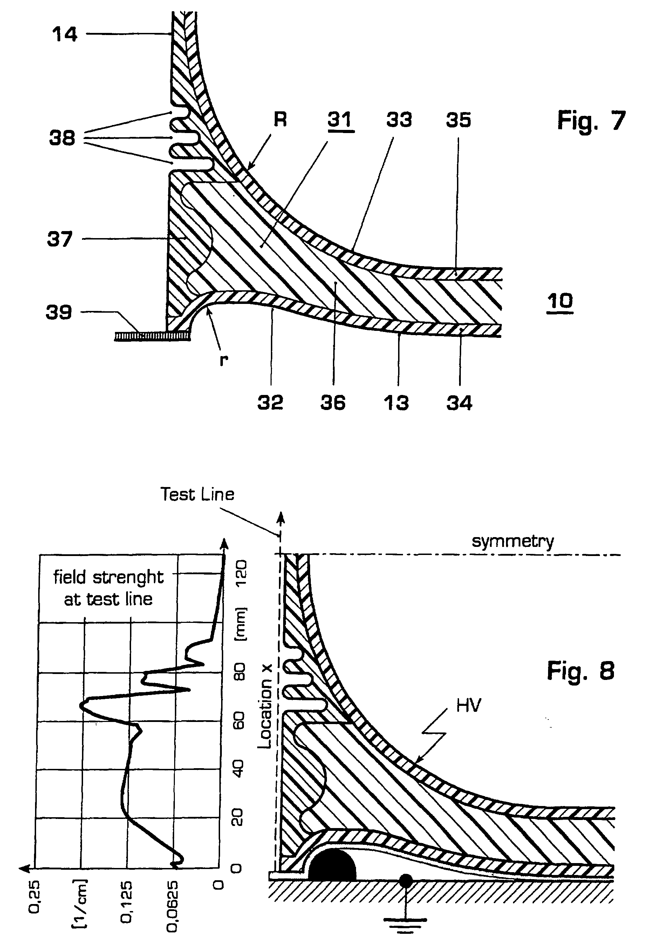

Aus Fig.7 sind die Ausbildung und die Werkstoffstruktur des Isolierstoffgehäuses 10 im dielektrisch besonders hoch beanspruchten Übergangsbereich von der Frontseite 13 auf die Seitenfläche 14 dargestellt. Dieser als Randprofil 31 ausgebildete dielektrisch hoch beanspruchte Bereich setzt sich in den an die Deck- 11 bzw. Bodenfläche 12 grenzenden Rändern der Seitenfläche 14 fort. Das dielektrisch hoch beanspruchte Randprofil 31 umgibt den in der Seitenfläche 14 vorgesehenen Kontakt 16 U-förmig (vgl. Figuren 4 und 6). Ein entsprechendes Profil ist auch an der Seitenfläche 15 vorgesehen. Das Randprofil 31 ist gewinkelt. Der in die Seitenfläche 14 erstreckte eine Schenkel des Winkels wird von dem mechanisch hochwertigen Werkstoff mit vergleichsweise grosser Dielektrizitätskonstanten gebildet. Der in die Frontseite 13, die Deckfläche 11 und die Bodenfläche 12 erstreckte Schenkel des Winkels weist Sandwichstruktur auf. Die Aussenfläche (gebildet von Frontseite 13 und Seitenfläche 14) und die Innenfläche 33 dieser Sandwichstruktur werden von Schichten 34, 35 jeweils aus dem Werkstoff mit der relativ grossen Dielektrizitätskonstanten gebildet. Eine dazwischenliegende relativ dicke Schicht 36 wird vom Werkstoff mit relativ kleiner Dielektrizitätskonstanten gebildet. Der Werkstoff der Sandwichstruktur weist so gesamthaft gegenüber dem Werkstoff in der Seitenfläche 14 eine relativ kleine Dielektrizitätskonstante auf. Durch diese Werkstoffstruktur wird die Vergleichmässigung des elektrischen Feldes auf der Oberfläche des Randprofils 31 wesentlich unterstützt.

Das Randprofil 31 weist auf seiner der leistungselektronischen Baugruppe 4 zugewandten Innenfläche 33 eine von einer elektrisch leitenden Beschichtung gebildete konkave Fläche mit einem grösseren Krümmungsradius R auf als eine auf ihrer Frontseite 13 angeordnete und gegenläufig gekrümmte, von einer elektrisch leitenden Beschichtung gebildete konkave Fläche 32 mit einem Radius r. Durch die Grössen der Radien und die gegenläufigen Krümmungen der elektrisch leitend ausgebildeten, vorzugsweise metallisierten Flächen 32, 33 wird das elektrische Feld im Randprofil 31 vergleichmässigt und wird so auf der nicht beschichteten Seitenfläche 14 das elektrische Feld noch besser verteilt.

Das Randprofil 31 weist eine U-förmig ausgebildete Wulst 37 aus dem Werkstoff der Seitenfläche 14 auf. Diese Wulst erstreckt sich vom Rand der Seitenfläche 14 in die Schicht 36 aus dem Werkstoff mit der kleinen Dielektrizitätskonstanten. Diese Wulst bewirkt zusammen mit dem Werkstoff der Schicht 36 eine zusätzliche Vergleichmässigung des elektrischen Feldes an dem auf der Seitenfläche 14 gelegenen Teil der Oberfläche des Randprofils 31. In die Seitenfläche 14 sind zusätzlich von der Wulst 37 umrandete, randparallel verlaufende Nuten 38 eingeformt. Diese Nuten bewirken zum einen eine Verringerung der elektrischen Feldstärke im Bereich der Wulst 37 und verlängern andererseits den Kriechweg entlang der Oberfläche des Randprofils 31 zwischen Masse bzw.Erdpotential und Hochspannungspotential (Kontakt 16). Der verlängerte Kriechweg ist insbesondere zur Verbesserung des Spannungsfestigkeit des Gehäuses 10 bei Verschmutzung und/oder bei Feuchtigkeit von Vorteil.

Die Wulst 37 und die Nuten 38 können in fertigungstechnisch vorteilhafter Weise in die Seitenfläche 14 eingepresst werden. An die konkave Aussenfläche 32 schliesst eine über die Seitenfläche 14 erstreckte Isolierbarriere 39 an. Diese Barriere verhindert das Starten von Oberflächenladungen, welche von Masse oder Erdpotential ausgehen.

Wie aus Fig.8 zu ersehen ist, ergibt sich im Bereich der Wulst 37 eine nahezu ortsunabhängige elektrische Feldstärke. Höhere Feldstärkespitzen treten zwar im Bereich der Nuten 38 auf. Diese Spitzen sind jedoch wegen der dort vorhandenen Luftisolierstrecken unkritisch. Die resultierenden Spannungsabfälle über den Nuten 38 reduzieren jedoch die elektrische Feldstärke längs der Oberfläche des Randprofils 31 im Bereich der Wulst 37. Ersichtlich steht an der Isolierstoffbarriere 39 eine besonders kleine elektrische Feldstärke an.

### Bezugszeichenliste

- 1: Stromabnehmer
- 2: Eingangsdrosselspule
- 3: Schaltungsanordnung
- 4: leistungselektronische Baugruppe
- 5: Transformator
- 6: leistungselektronische Baugruppe
- 7: Stromrichtersystem
- 8: Motor
- 9: Platte
- 10: Isolierstoffgehäuse
- 11: Deckfläche
- 12: Bodenfläche
- 13: Frontseite
- 14, 15: Seitenflächen
- 16, 17: Kontakte
- 18: Doppelpfeil
- 19: Führungsfläche
- 20: Stifte
- 21: Führungselement
- 22, 23: Handgriffe
- 24: Rollen
- 25: Zwischenwand
- 26, 27: Kabelendverschlüsse
- 28: Steuerelektrode
- 29: Kühlkanäle
- 30: U-förmiger Wandabschnitt
- 31: Randprofil
- 32: konkave Fläche
- 33: Innenfläche
- 34, 35, 36: Schichten
- 37: Wulst
- 38: Nuten
- 39: Isolierstoffbarriere

## Patentansprüche

1. Modul (M1, M2,...) einer, vorzugsweise in einem Antrieb für ein Schienenfahrzeug enthaltenen, modular aufgebauten Schaltungsanordnung, mit einer auf Hochspannungspotential befindlichen ersten leistungselektronischen Baugruppe (4), einer auf niedrigerem Potential befindlichen zweiten leistungselektronischen Baugruppe (6) und einem die erste und die zweite Baugruppe (4, 6) unter Bildung einer galvanischen Trennstelle koppelnden Transformator (5), **dadurch gekennzeichnet, dass** die erste Baugruppe (4) und damit verbundene Stromanschlüsse des Transformators (5) in einem weitgehend quaderförmig ausgebildeten Isolierstoffgehäuse (10) angeordnet sind, dass das Isolierstoffgehäuse (10) auf seiner Deck- (11) und Bodenfläche (12) sowie auf seiner nach vorne abgeschlossenen Frontseite (13) jeweils eine auf Masse oder Erdpotential geführte elektrisch leitende Schicht aufweist, dass durch die beiden Seitenflächen (14, 15) des Moduls (M1, M2,...) jeweils ein Stromanschluss der ersten leistungselektronischen Baugruppe (4) geführt ist, und dass die elektrische Isolierung zwischen der ersten leistungselektronischen Baugruppe (4) und den auf Masse oder Erdpotential geführten elektrisch leitenden Schichten einen im wesentlichen U-förmig ausgebildeten und von der Deckfläche (11) Ober die Frontseite (13) auf die Bodenfläche (12) erstreckten Abschnitt (30) der Wand des Isoliergehäuses (10) umfasst.

2. Modul nach Anspruch 1, **dadurch gekennzeichnet, dass** zusätzlich der Transformator (5) und die zweite leistungselektronische Baugruppe (6) im Isolierstoffgehäuse (10) angeordnet sind, und dass das Isolierstoffgehäuse (10) ferner eine isolierende Zwischenwand (25) aufnimmt, welche die erste Baugruppe (4) vom Transformator (5) und der zweiten Baugruppe (6) trennt, und durch welche die auf Hochspannungspotential befindlichen Stromanschlüsse des Transformators (5) geführt sind.

3. Modul nach Anspruch 2, **dadurch gekennzeichnet, dass** die Durchführungen der Stromanschlüsse des Transformators (5) nach Art eines Kabelendverschlusses (26, 27) ausgeführt sind.

4. Modul nach Anspruch 3, **dadurch gekennzeichnet, dass** die Kabelendverschlüsse (26, 27) fest mit der Zwischenwand (25) verbunden sind und in einen durch eine kappenförmige Steuerelektrode (28) abgeschirmten, die erste leistungselektronische Baugruppe (4) aufnehmenden Raum ragen.

5. Modul nach einem der Ansprüche 2 bis 4, **dadurch gekennzeichnet, dass** in die Zwischenwand Kühlkanäle (29) eingeformt sind.

6. Modul nach einem der Ansprüche 2 bis 5, **dadurch gekennzeichnet, dass** die Zwischenwand (25) mit dem Transformator (5) fest verbunden ist.

7. Modul nach einem der Ansprüche 2 bis 6, **dadurch gekennzeichnet, dass** die erste und die zweite leistungselektronische Baugruppe (4, 6) sowie der Transformator (5) in das Isolierstoffgehäuse (10) eingesteckt sind.

8. Modul nach einem der Ansprüche 1 bis 7, **dadurch gekennzeichnet, dass** zwischen der ersten leistungselektronischen Baugruppe (4) und dem U-förmigen Wandabschnitt (30) des Isolierstoffgehäuses (10) eine vom U-förmigen Wandabschnitt (30) beabstandete kappenförmige Steuerelektrode (28) angeordnet ist, deren Abstand von der Frontseite (13) des Isolierstoffgehäuses (10) zur galvanischen Trennstelle hin zunimmt.

9. Modul nach Anspruch 8, **dadurch gekennzeichnet, dass** die Steuerelektrode (28) aus elektrisch leitendem Kunststoff besteht und auf ihrer Innenseite eine metallische Beschichtung aufweist.

10. Modul nach einem der Ansprüche 1 bis 9, **dadurch gekennzeichnet, dass** der U-förmige Wandabschnitt (30) des Isolierstoffgehäuses (10) eine geringere elektrische Kapazität pro Flächeneinheit aufweist als dessen die Seitenflächen (14, 15) bildenden Wandabschnitte.

11. Modul nach Anspruch 10, **dadurch gekennzeichnet, dass** die Dicke des Wandabschnitts (30) grösser ist als diejenige der Seitenflächen (14, 15).

12. Modul nach einem der Ansprüche 10 oder 11, **dadurch gekennzeichnet, dass** der U-förmige Wandabschnitt (30) einen Werkstoff mit einer geringeren Dielektrizitätskonstanten enthält als die Seitenflächen (14, 15).

13. Modul nach Anspruch 12, **dadurch gekennzeichnet, dass** der Werkstoff des U-förmigen Wandabschnitts (30) Porenstruktur aufweist und vorzugsweise als Schaumstoff oder als hohlkörpergefüllter Kunststoff ausgeführt ist.

14. Modul nach Anspruch 12 oder 13, **dadurch gekennzeichnet, dass** der U-förmige Wandabschnitt (30) Sandwichstruktur aufweist mit einer die Aussenund einer die Innenfläche (33) des Wandabschnitts (30) bildenden Schicht (34, 35) jeweils aus einem mechanisch hochwertigen Isoliermaterial und einer dazwischen angeordneten dickeren Schicht (36) aus dem Werkstoff mit geringer Dielektrizitätskonstanten.

15. Modul nach einem der Ansprüche 1 bis 14, **dadurch gekennzeichnet, dass** in den U-förmigen Wandabschnitt (30) mindestens ein in eine der beiden Seitenflächen (14) übergehendes Randprofil (31) eingeformt ist, welches auf seiner der hochspannungsführenden leistungselektronischen Baugruppe (4) zugewandten Innenseite jeweils eine erste konkave Fläche (33) mit einem grösseren Krümmungsradius (R) aufweist als eine auf seiner Aussenseite angeordnete und gegenläufig gekrümmte zweite konkave Fläche (32).

16. Modul nach Anspruch 15, **dadurch gekennzeichnet, dass** das mindestens eine Randprofil (31) eine U-förmig ausgebildete Wulst (37) aus dem Werkstoff der Seitenfläche (14, 15) aufweist, welche sich vom Rand der zugeordneten Seitenfläche (14) in den Werkstoff mit der geringeren Dielektrizitätskonstanten als der Werkstoff der Seitenflächen (14, 15) erstreckt.

17. Modul nach Anspruch 16, **dadurch gekennzeichnet, dass** in die der Wulst (37) zugeordnete Seitenfläche (14) von der Wulst (37) umrandete, randparallel verlaufende Nuten (38) eingeformt sind.

18. Modul nach Anspruch 17, **dadurch gekennzeichnet, dass** die Wulst (37) und die Nuten (38) in die Seitenfläche (14) eingepresst sind.

19. Modul nach einem der Ansprüche 15 bis 18, **dadurch gekennzeichnet, dass** die erste und die zweite konkave Fläche (32, 33) mit einer metallischen Beschichtung versehen sind.

20. Modul nach einem der Ansprüche 15 bis 19, **dadurch gekennzeichnet, dass** an die zweite konkave Fläche (32) eine die Seitenfläche (14) überragende Isolierbarriere (39) anschliesst.

## Claims

1. A module (M1, M2 ...) of a circuit arrangement which is preferably contained in a drive for a railroad vehicle and is of modular construction, having a first power-electronics assembly (4) which is at high voltage, a second power-electronics assembly (6) which is at a lower potential, and a transformer (5) which couples the first assembly (4) and the second assembly (6) forming a DC isolation point, **characterised in that** the first assembly (4) and electrical connections of the transformer (5) which are connected to it are arranged in a dielectric material housing (10) which is largely designed in a cuboid shape, that the dielectric material housing (10) in each case has an electrically conductive layer, which is connected to frame or ground potential, on its top surface (11) and bottom surface (12) as well as on its front face (13) which is closed at the front, that an electrical connection of the first power-electronics assembly (4) is passed through each of the two side surfaces (14, 15) of the module (M1, M2, ...), and **in that** the electrical insulation between the first power-electronics assembly (4) and the electrically conductive layers, which are connected to frame or ground potential, comprises a section (30) of the wall of the dielectric housing (10), which section (30) is designed essentially in U-shape and extends from the top surface (11), over the front face (13), to the bottom surface (12).

2. The module according to claim 1, **characterised in that**, in addition, the transformer (5) and the second power-electronics assembly (6) are arranged in the dielectric material housing (10), and that the dielectric material housing (10) furthermore accommodates an insulating intermediate wall (25) which separates the first assembly (4) from the transformer (5) and from the second assembly (6), and through which the electrical connections of the transformer (5), which are at high voltage, are passed.

3. The module according to claim 2, **characterised in that** the ducts of the electrical connections of the transformer (5) are designed in the form of a cable termination (26, 27).

4. The module according to claim 3, **characterised in that** the cable terminations (26, 27) are firmly connected to the intermediate wall (25) and project into a space which is shielded by a control electrode (28) in the form of a cap and accommodates the first power-electronics assembly (4).

5. The module according to any of claims 2 to 4, **characterised in that** cooling channels (29) are formed in the intermediate wall.

6. The module according to any of claims 2 to 5, **characterised in that** the intermediate wall (25) is firmly connected to the transformer (5).

7. The module according to any of claims 2 to 6, **characterised in that** the first and the second power-electronics assembly (4, 6) as well as the transformer (5) are inserted into the dielectric material housing (10).

8. The module according to any of claims 1 to 7, **characterised in that** a control electrode (28) is arranged between the first power-electronics assembly (4) and the U-shaped wall section (30) of the dielectric material housing (10), which control electrode (28) is at a distance from the U-shaped wall section (30) and is in the form of a cap, and whose distance from the front face (13) of the dielectric material housing (10) increases toward the DC isolation point.

9. The module according to claim 8, **characterised in that** the control electrode (28) is composed of electrically conductive plastic and has a metallic coating on its inside.

10. The module according to any of claims 1 to 9, **characterised in that** the U-shaped wall section (30) of the dielectric material housing (10) has less electrical capacitance per unit area than its wall sections which form the side surfaces (14, 15).

11. The module according to claim 10, **characterised in that** the thickness of the wall section (30) is greater than that of the side surfaces (14, 15).

12. The module according to claim 10 or 11, **characterised in that** the U-shaped wall section (30) contains a material having a lower dielectric constant than the side surfaces (14, 15).

13. The module according to claim 12, **characterised in that** the material of the U-shaped wall section (30) has a pore structure, and is preferably in the form of foam, or plastic filled with hollow bodies.

14. The module according to claim 12 or 13, **characterised in that** the U-shaped wall section (30) has a sandwich structure with a layer (34) which forms the outer surface of the wall section (30) and a layer (35) which forms the inner surface (33) of the wall section (30), which layers are each composed of a mechanically high-quality insulating material, and having a thicker layer (36) which is arranged in between and is composed of the material having a low dielectric constant.

15. The module according to any of claims 1 to 14, **characterised in that** at least one rim profile (31) is formed in the U-shaped wall section (30), merges into one of the two side surfaces (14) and in each case has on its inner side facing the power-electronics assembly (4) which carries high voltage a first concave surface (33) having a greater radius of curvature than a second concave surface (32) which is arranged on its outer side and is curved in the opposite direction.

16. The module according to claim 15, **characterised in that** the at least one rim profile (31) has a bead (37) which is designed in a U-shape, is composed of the same material as the side surface (14, 15) and extends from the rim of the associated side surface (14) into the material whose dielectric constant is less than that of the material of the side surfaces (14, 15).

17. The module according to claim 16, **characterised in that** grooves (38) which are surrounded by the bead (37) and run parallel to the rim are formed in the side surface (14) which is associated with the bead (37).

18. The module according to claim 17, **characterised in that** the bead (37) and the grooves (38) are stamped into the side surface (14).

19. The module according to any of claims 15 to 18, **characterised in that** the first concave surface (32) and the second concave surface (33) are provided with a metallic coating.

20. The module according to any of claims 15 to 19, **characterised in that** an insulating barrier (39) which projects beyond the side surface (14) is adjacent to the second concave surface (32).

## Revendications

1. Module (M1, M2,...) d'un assemblage de circuits contenu de préférence dans un mécanisme d'entraînement d'un véhicule ferroviaire, construit de manière modulaire, comportant un premier groupe (4) d'électronique de puissance se trouvant sur un potentiel haute tension, un deuxième groupe (6) d'électronique de puissance se trouvant sur un potentiel inférieur et un transformateur (5) couplant le premier et le deuxième groupe (4, 6) en formant un point de sectionnement galvanique, **caractérisé en ce que** le premier groupe (4) et les raccordements électriques du transformateur (5) qui y sont reliés sont disposés dans un boîtier de matière isolante (10) configuré essentiellement en forme de bloc, **en ce que** le boîtier de matière isolante (10) présente respectivement sur sa surface de couvercle (11) et de base (12) ainsi que sur son côté frontal (13) fermé vers l'avant une couche conductrice d'électricité branchée à la masse ou sur un potentiel de terre, **en ce qu'**un raccordement électrique du premier groupe d'électronique de puissance (4) est introduit respectivement à travers les deux surfaces latérales (14, 15) du module (M1, M2,...) et **en ce que** l'isolation électrique entre le premier groupe d'électronique de puissance (4) et les couches conductrices d'électricité branchées à la masse ou sur un potentiel de terre comprend une section (30) de la paroi du boîtier isolant (10) essentiellement configurée en forme de U et s'étendant de la surface de couvercle (11) à la surface de base (12) en passant par le côté frontal (13).

2. Module selon la revendication 1, **caractérisé en ce que** la transformateur (5) et le deuxième groupe d'électronique de puissance (6) sont en plus disposés dans le boîtier de matière isolante (10) et **en ce que** le boîtier de matière isolante (10) renferme en outre une couche intermédiaire isolante (25), laquelle sépare le premier groupe (4) du transformateur (5) et du deuxième groupe (6) et à travers laquelle les raccordements électriques du transformateur (5) se trouvant sur le potentiel haute tension sont introduits.

3. Module selon la revendication 2, **caractérisé en ce que** les traversées des raccordements électriques du transformateur (5) sont réalisées sous la forme du boîte d'extrémité de câbles (26, 27).

4. Module selon la revendication 3, **caractérisé en ce que** les boîtes d'extrémité de câbles (26, 27) sont solidement reliées à la paroi intermédiaire (25) et saillent dans un espace renfermant le premier groupe (4) d'électronique de puissance, protégé par une électrode de commande (28) en forme de chapeau.

5. Module selon une des revendications 2 à 4, **caractérisé en ce que** des canaux de refroidissement (29) sont formés dans la paroi intermédiaire.

6. Module selon une des revendications 2 à 5, **caractérisé en ce que** la paroi intermédiaire (25) est solidement reliée au transformateur (5).

7. Module selon une des revendications 2 à 6, **caractérisé en ce que** le premier et le deuxième groupe d'électronique de puissance (4, 6) ainsi que le transformateur (5) sont enfichés dans le boîtier de matière isolante (10).

8. Module selon une des revendications 1 à 7, **caractérisé en ce que**, entre le premier groupe d'électronique de puissance (4) et la section de paroi (30) en forme de U du boîtier de matière isolante (10), une électrode de commande (28) en forme de chapeau espacée de la section de paroi (30) en forme de U est disposée, dont l'espacement du côté frontal (13) du boîtier de matière isolante (10) vers le point de sectionnement galvanique va en augmentant.

9. Module selon la revendication 8, **caractérisé en ce que** l'électrode de commande (28) est constituée d'un matériau conducteur d'électricité et présente un revêtement métallique sur son côté interne.

10. Module selon une des revendications 1 à 9, **caractérisé en ce que** la section de paroi (30) en forme de U du boîtier de matière isolante (10) présente une capacité électrique par unité de surface plus petite que les sections de paroi formant les surfaces latérales (14, 15) dudit boîtier.

11. Module selon la revendication 10, **caractérisé en ce que** l'épaisseur de la section de paroi (30) est plus grande que celle des surfaces latérales (14, 15).

12. Module selon une des revendications 10 ou 11, **caractérisé en ce que** la section de paroi (30) en forme de U contient un matériau à constante diélectrique plus petite que les surfaces latérales (14, 15).

13. Module selon la revendication 12, **caractérisé en ce que** le matériau de la section de paroi (30) en forme de U présente une structure à pores et est de préférence réalisé comme une matière plastique mousse ou comme un plastique rempli de corps creux.

14. Module selon la revendication 12 ou 13, **caractérisé en ce que** la section de paroi (30) en forme de U présente une structure en sandwich, avec une couche (34) formant respectivement la surface extérieure et une couche (35) formant la surface intérieure (33) de la section de paroi (30), constituées d'un matériau isolant mécanique de qualité supérieure, et une couche (36) plus épaisse disposée entre ces dernières, constituée du matériau à constante diélectrique plus petite.

15. Module selon une des revendications 1 à 14, **caractérisé en ce que** au moins un profilé de bord (31) allant dans une des deux surfaces latérales (14) est formé dans la section de paroi (30) en forme de U, lequel présente, sur son côté interne tourné vers le groupe d'électronique de puissance (4) branché sur haute tension, respectivement une première surface concave (33) avec un rayon de courbure (R) plus grand qu'une deuxième surface concave (32) disposée sur son côté externe et recourbée en sens inverse.

16. Module selon la revendication 15, **caractérisé en ce que** au moins un profilé de bord (31) présente un bourrelet (37) réalisé en forme de U, constitué du matériau des surfaces latérales (14, 15), lequel s'étend à partir du bord de la surface latérale (14) coordonnée dans le matériau à constante diélectrique plus petite que le matériau des surfaces latérales (14, 15).

17. Module selon la revendication 16, **caractérisé en ce que**, dans la surface latérale (14) coordonnée au bourrelet (37), des rainures (38) s'étendant parallèlement aux bords, bordées par le bourrelet (37) sont formées.

18. Module selon la revendication 17, **caractérisé en ce que** le bourrelet (37) et les rainures (38) sont façonnés par pressage dans la surface latérale (14).

19. Module selon une des revendications 15 à 18, **caractérisé en ce que** la première et la deuxième surface concave (32, 33) sont pourvues d'un revêtement métallique.

20. Module selon une des revendications 15 à 19, **caractérisé en ce que** la deuxième surface concave (32) est contiguë à une barrière isolante (39) saillant sur la surface latérale (14).
